# EUROPEAN PATENT APPLICATION

(11) **EP 4 546 341 A1**
(43) Date of publication of application: **30.04.2025**
(21) Application number: 24208876.3
(22) Date of filing: 25.10.2024
(51) Int. Cl.: G11C 5/02, G11C 5/06, H01L 23/48, H01R 12/52

(54) **MULTI-DIRECTIONAL SHARING AND MULTIPLEXING FOR HIGH BANDWIDTH MEMORY**

(30) Priority: 25.10.2023 US 202363545587 P; 22.10.2024 US 202418923025
(71) Applicant: Google LLC, Mountain View, CA 94043 (US)
(72) Inventor: TOMA, Horia Alexandru, Mountain View, California, 94043 (US); NAGARAJAN, Rahul, San Jose, California, 94043 (US); SHIM, Yujeong, Mountain View, California, 95130 (US); PADMANABHAN, Rammohan, Mountain View, California, 94043 (US)
(74) Representative: Betten & Resch

(57) **Abstract**

Generally disclosed herein are electronic circuits with high bandwidth interfaces (HBI) for multi-directional die-to-die communications. The HBIs are designed to allow for sharing of data between all sides of the memory chiplets. By using all sides of the memory chiplets and multiplexing the data between the multiple connected chiplets, the total bandwidth of the memory available to the connected chiplets can increase. The sharing and multiplexing of the data can also be dynamically configured to accommodate various options for the allocation of performance levels and the associated cost.

## Description

### CROSS-REFERENCE TO RELATED APPLICATIONS

This application claims the benefit of the filing date of United States Provisional Patent Application No. 63/545,587 filed October 25, 2023, the disclosure of which is hereby incorporated herein by reference.

### BACKGROUND

High Bandwidth Memory (HBM) is a high-speed computer memory interface for 3D-stacked synchronous dynamic random-access memory (SDRAM). It is used in conjunction with high-performance graphics accelerators, network devices, high-performance datacenter application-specific integrated circuits (ASICs), etc. HBM achieves high bandwidth while using less power by stacking dynamic random access memory (DRAM) dies. The stack is often connected to a memory controller on a central processing unit (CPU), either directly or through a substrate. The HBM DRAM is coupled to the host compute die with a distributed interface, which may be divided into independent channels.

HBM typically uses a communication solution that can serve only one preferred direction in a package. Such a unidirectional communication solution can have disadvantages. For example, memory chiplets typically have a rectangular shape with an interface near one edge, allowing for connection to one other chiplet. If the chiplet connected to the memory chiplet is not perfectly aligned, the resulting discrepancy has a negative impact on the performance.

### SUMMARY

Generally disclosed herein are electronic circuits with high bandwidth interfaces (HBI) for multi-directional die-to-die communications. The HBIs are designed to allow for sharing of data from multiple sides of memory chiplets. By using multiple sides of the memory chiplets and multiplexing data received from multiple connected chiplets, the total bandwidth of the memory available to the connected chiplets can increase. The sharing and multiplexing of the data can also be dynamically configured to accommodate various options for the allocation of performance levels.

An aspect of the disclosure provides an electronic circuit, comprising a first chiplet having a first surface and a plurality of edges at a perimeter of the first surface, and at least one shoreline interface at one or more of the plurality of edges, the at least one shoreline interface extending along a length of the first chiplet; and at least one second chiplet having a second surface and a plurality of edges at a perimeter of the second surface, and at least one die-to-die interface being located at one of the plurality of edges; wherein the at least one shoreline interface is adapted to couple to the at least one die-to-die interface; and wherein at least one of the first or second chiplet is a high bandwidth memory chiplet and at least one of the first or second chiplet is a compute chiplet.

In some examples, the shoreline interface comprises multiple channels.

In some examples, the electronic circuit may include a third chiplet having an interface coupled to a second shoreline interface of the first chiplet.

In some examples, the first chiplet may be configured to communicate with the second chiplet and the third chiplet at equal bandwidth or uneven bandwidths.

In some examples, the first chiplet may be configured to dynamically change relative bandwidth for a communication with the second chiplet as compared to a communication with the third chiplet.

In some examples, the first chiplet may include a multicast module configured to dynamically allocate bandwidth among the shoreline interface and the second shoreline interface based on a performance rate.

In some examples, the first chiplet may be configured to multiplex data received from the second chiplet and the third chiplet.

In some examples, the multiple channels of the shoreline interface may be activated or deactivated.

In some examples, the circuit may include a fourth chiplet, wherein the first, second, third, and fourth chiplets are configured to be arranged in a tile shape such that each chiplet couples to at least two other chiplets.

In some examples, the first, second, third, and fourth chiplets may be configured to form a systolic array.

In some examples, the shoreline interface may be configured to extend along an entire length of the first chiplet or less than an entire length of the first chiplet.

Another aspect of the disclosure provides a high bandwidth memory (HBM) chiplet, comprising a first surface and a plurality of edges at a perimeter of the first surface, and at least one shoreline interface at one or more of the plurality of edges, the at least one shoreline interface extending along a length of the HBM chiplet; wherein the at least one shoreline interface is adapted to couple to a die-to-die interface located at one of a plurality of edges of a first connected chiplet.

In some examples, the shoreline interface comprises multiple channels.

In some examples, the HBM chiplet further comprises a second shoreline interface coupled to an interface of a second connected chiplet.

In some examples, the HBM chiplet is configured to communicate with the first connected chiplet and the second connected chiplet at equal bandwidth.

In some examples, the HBM chiplet is configured to communicate with the first connected chiplet and the second connected chiplet at uneven bandwidth.

In some examples, the HBM chiplet is configured to dynamically change relative bandwidth for a communication with the first connected chiplet as compared to a communication with the second connected chiplet.

Yet another aspect of the disclosure provides a compute chiplet comprising a first surface and a plurality of edges at a perimeter of the first surface, and at least one die-to-die interface being located at one of the plurality of edges; wherein the at least one die-to-die interface is adapted to be coupled to at least one shoreline interface of a first connected chiplet, the first connected chiplet comprising a second surface and a plurality of edges at a perimeter of the second surface and the at least one shoreline interface at one or more of the plurality of edges extending along a length of the first connected chiplet.

### BRIEF DESCRIPTION OF THE DRAWINGS

FIG. 1 is a schematic representation of memory and compute chiplets with full die-to-die interfaces in accordance with aspects of the disclosure.
FIG. 2 is a schematic representation of memory chiplets with various die-to-die interfaces for multidirectional communication in accordance with aspects of the disclosure.
FIG. 3 is a schematic representation of a memory chiplet for even and uneven sharing and multiplexing of data using all sides in accordance with aspects of the disclosure.
FIG. 4 illustrates example configurations of memory and compute chiplets in various tile arrangements in accordance with aspects of the disclosure.
FIG. 5 illustrates an example of repeated tile configurations of memory and compute chiplets in accordance with aspects of the disclosure.
FIG. 6 illustrates an example systolic array arrangement of memory and compute chiplets in accordance with aspects of the disclosure.
FIG. 7 is a flow diagram illustrating an example method for multi-directional sharing and multiplexing of data using high bandwidth interfaces in accordance with aspects of the disclosure.

### DETAILED DESCRIPTION

The present disclosure relates to electronic circuits with high bandwidth interfaces (HBI) for multi-directional die-to-die communications. A shoreline interface can be implemented to eliminate the need for any offset or discrepancies between the length of the interfaces between two connected chiplets. A shoreline interface may refer to a die-to-die interface extending along the entire length of one edge of the chiplet. The shoreline interface can be replicated on any one or more sides of the chiplets. Sharing and multiplexing modules can be implemented to combine any specific unit of memory and compute chiplets to form larger units of the chiplets in various forms and shapes.

According to some examples, it may not be necessary for the interface to densely cover the whole shoreline of the chiplet with communication channels, as long as the interface can provide enough density of bandwidth per millimeter to enable connectivity to any necessary connected chiplets. The die-to-die shoreline interfaces can be replicated on all four sides of the chiplets to enable full connectivity. In some examples, the interface may be replicated on fewer than all sides of the memory chiplet.

Each shoreline interface may include multiple independent channels and pseudo-channels. An independent channel may be divided into two pseudo-channels. Pseudo-channels may operate semi-independently although the pseudo-channels share the same address and command bus but each pseudo-channel decodes and executes commands individually. According to some examples, any number of the interfaces may be activated or deactivated according to the number of the connected chiplets that receive data from the memory chiplet. Static interfaces may be configured to allow for sharing and multicasting to any subset of connected interfaces. In other examples, different numbers of channels within each interface may be activated to allow for adjustment of allocation of data flow from the memory chiplet to any connected processing chiplets to maximize performance based on the specific needs of requested computing workloads.

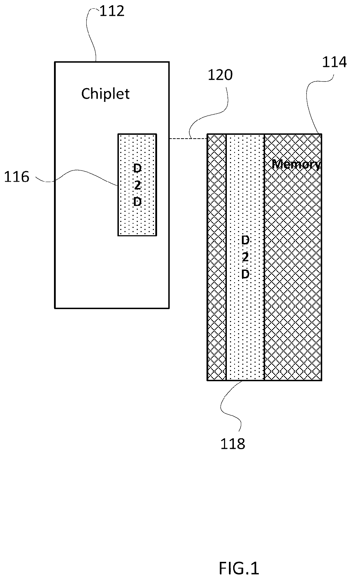

FIG. 1 is a schematic representation of memory and compute chiplets with shoreline interfaces.

As shown, compute chiplet 112 has a length of L1 and includes chiplet D2D interface 116 extending along a portion of the length L1. Memory chiplet 114 has a length of L2 and includes a memory D2D interface 118 extending along substantially the entire length of L2 near an edge portion of the chiplet 114. The memory D2D interface 118 may be referred to as a shoreline interface because of its length and proximity to the edge. The chiplet D2D interface 116 may be connected to memory D2D interface 118. Because the memory D2D interface 118 extends along substantially an entire length L2 of the chiplet 114, the likelihood of chiplet D2D interface 116 aligning with the memory D2D interface 118 is increased as compared to an arrangement without a shoreline interface. Even if the boundaries of chiplet 112 are offset from the boundaries of memory chiplet 114, such as shown in the illustrated example where a top edge of the chiplet 112 is higher as compared to a top edge of the chiplet 114, a connected length of chiplet D2D interface 116 is maximized.

For example, as shown, an entire length of D2D interface 116 may align with the shoreline memory D2D interface 118. The chiplet 112 can be arranged such that a top edge of chiplet D2D interface 116 aligns with a top edge of memory chiplet 114, as illustrated by dotted line 120. According to some examples, the channels within memory D2D interface 118 that are not connected to chiplet D2D interface 116 may be deactivated. For example, a bottom portion of memory D2D interface 118 that extends beyond a bottom edge of D2D interface 116 may be deactivated. If the position of chiplet 112 is moved downward, the channels within the bottom portion of memory D2D interface 118 may be re-activated and the channels within the upper portion of memory D2D interface 118 may be deactivated.

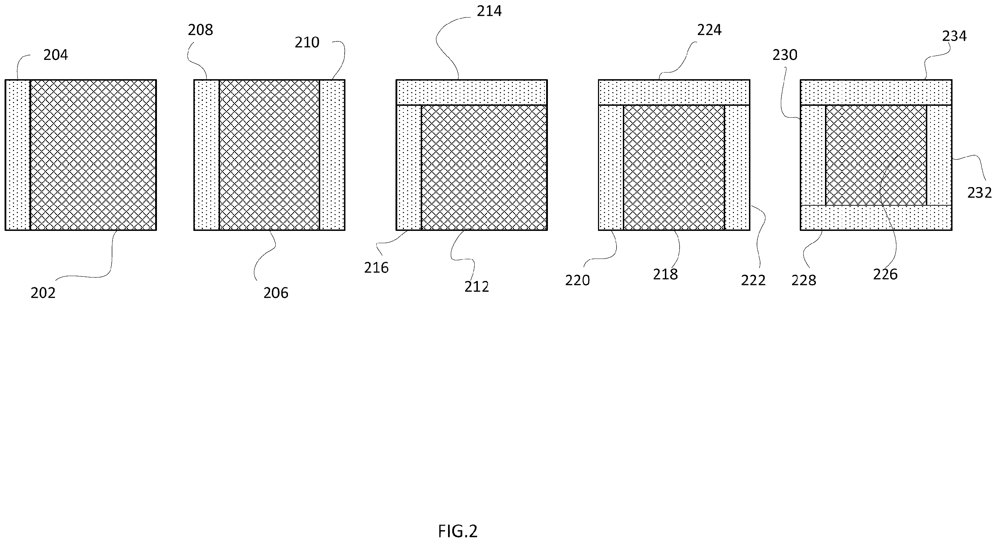

FIG. 2 is a top-view schematic representation of memory chiplets with die-to-die interfaces for multidirectional communication. Memory chiplet 202 may include D2D interface 204 placed near a left edge of a first surface of the memory chiplet 202. The first surface may be, for example, a top surface. Memory chiplet 206 may include D2D interface 208 near the left edge and D2D interface 210 near the right edge of memory chiplet 206. Memory chiplet 212 may include D2D interface 216 near the left edge and D2D interface 214 in an upper region of memory chiplet 212. Memory chiplet 218 may include D2D interface 220 near the left edge, D2D interface 222 near the right edge, and D2D interface on the upper portion of memory chiplet 218. Memory chiplet 226 may include D2D interfaces 228, 230, 232, and 234 near all edges of the first surface of memory chiplet 226.

Memory chiplets 202, 206, 212, 218, and 226 are shown in rectangular shapes for illustration purposes only. Memory chiplets 202, 206, 212, 218, and 226 may be formed in any other shapes such as rectangular, trapezoid, pentagon, hexagon, etc. While the D2D interfaces are illustrated as extending along an entire shoreline of the chiplet, with a width starting from an edge of the chiplet and extending towards a middle portion of the chiplet, it should be understood that the length, width, shape, and position of the interface can be varied. By way of example only, the interface can have a narrower or wider width than the example shown. As another example, the interface may be positioned near an edge of the chiplet, but its width may not extend all the way to the edge.

According to some examples, the number of the activated channels within each of the above D2D interfaces may be dynamically adjusted in accordance with the length of the respective D2D interfaces equipped in the connected chiplets. For example, each of D2D interfaces 228, 230, 232, and 234 can have different numbers of activated channels contingent on the length of the D2D interfaces of the connected chiplets (not shown).

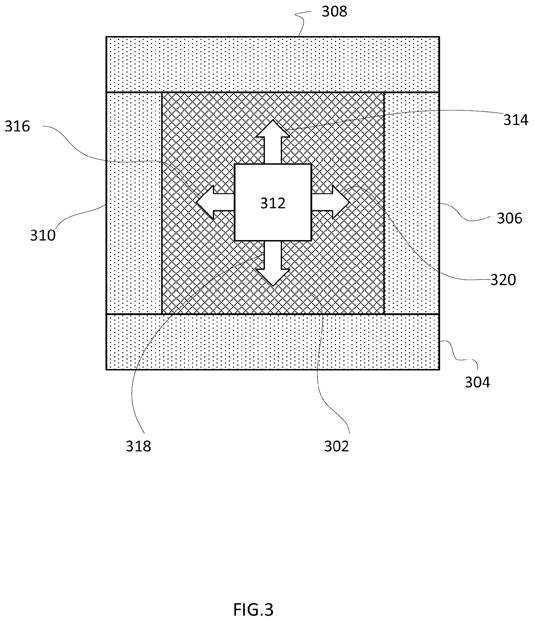

FIG. 3 is a schematic representation of a memory chiplet for sharing and multiplexing data using all sides. The data may be shared evenly or unevenly. For example, for uneven sharing, data transmitted through a first interface may have a higher bandwidth as compared to data transmitted through a second interface. For even sharing, data may be transmitted at equal bandwidth through each interface.

As shown, memory chiplet 302 includes D2D interfaces 304, 306, 308, and 312 placed at all edges of a top surface of memory chiplet 302. In other examples, interfaces may be arranged at fewer than all edges. Controller 312 may be configured to evenly or unevenly adjust the amount of data transmitted from memory chiplet 302 in any of four directions: N direction 314, E direction 320, S direction 318 and W direction 316. For example, if there is only one connected chiplet coupled to D2D interface 308 of memory chiplet 302, and no other chiplets are connected to other sides of memory chiplet 302, controller 312 may send 100% of the amount of data to the connected chiplet through D2D interface 308. If memory chiplet 302 is coupled to two connected chiplets, such as one connected via D2D interface 308 and another connected via D2D interface 310, controller 312 may send 50% of data in N direction 314 and another 50% in W direction 316.

According to some examples, controller 312 may adjust the amount of data sent in each direction. For example, 75% of data may be sent in N direction 314 and 25% sent in W direction 316. If three connected chiplets are connected to D2D interfaces 304, 306 and 308, 1/3 of data may be sent in each direction or the individual percentages may be changed according to the need of data at each connected chiplet. Controller 312 may send the data from memory chiplet 302 to the connected chiplets connected to all four sides of memory chiplet 302. Even sharing of data may be configured by sharing 25% of the data with a connected chiplet in N direction 314, 25% of the data with another connected chiplet in W direction 316, 25% of the data with the other connected chiplet in E direction 320 and the last 25% of the data with the other connected chiplet in S direction 318. Controller 312 may modify the amount of data going into each direction in an uneven way while maintaining the sum of the amount of data to be consistent. In some examples, controller 312 may use a multicast module configured to dynamically allocate bandwidth among the shoreline interfaces and the connected chiplets based on each connected chiplet's performance rate.

Memory chiplet 302 may receive data from the connected chiplets and multiplex the received data. Controller 312 may configure the memory chiplet 312 to multiplex the received data and send either evenly or unevenly in all four directions. For example, where bandwidth is allocated evenly among multiple interfaces, data may be received or transmitted across such multiple interfaces at the same rate. Conversely, if bandwidth is unevenly allocated, data may be received/transmitted across a first shoreline interface of the chiplet at a different rate as compared to data received/transmitted across a second shoreline interface of the chiplet. According to some examples, controller 312 may dynamically select one of the above-described four modes, "even sharing" mode, "uneven sharing" mode, "even multiplexing" mode, or "uneven multiplexing" mode as the magnitudes of requested data flow from the connected chiplet change.

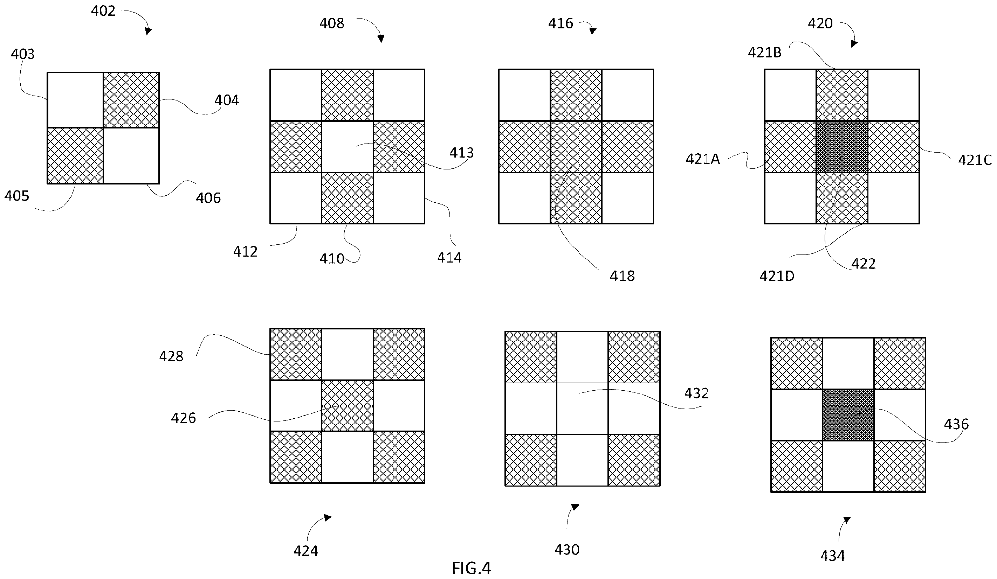

FIG. 4 illustrates example configurations of memory and compute chiplets in various tile arrangements. Arrangement 402 may include two memory chiplets and two compute chiplets arranged in a 2x2 square shape. At least two sides of each memory chiplet can be configured to be fully connected with the neighboring compute chiplets for communication. Arrangement 402 may include compute chiplets 403 and 406 and memory chiplets 404 and 405. Memory chiplet 404 may send data to compute chiplets 403 and 406. Memory chiplet 405 may send data to compute chiplet 403 and 406. Memory chiplet 404 may send either equal or unequal amount of data to compute chiplet 403 and 406.

Arrangement 408 may include four memory chiplets (illustrated by shadowed boxes) and five compute chiplets. At least the three sides of the memory chiplet can be connected to the compute chiplets for communication. For example, memory chiplet 410 may be connected to compute chiplets 412, 413, and 414. Memory chiplet 410 may either evenly or unevenly send data to each compute chiplet 412, 413, and 414.

Arrangement 416 is a variation of arrangement 404 with one more memory chiplet placed in the center. All sides of memory chiplet 418 are connected to other memory chiplets. Memory chiplet 418 may store the data received from each connected memory chiplets.

Arrangement 420 may include a logic die in the center (illustrated by a darkened box). For the purpose of this disclosure, a logic die may only perform routing and communication, and not store memory or perform computation. The logic die may be placed in the center to move data as fast as possible in all directions. For example, logic die 422 may send the data received from memory chiplet 421A to either memory chiplets 421B, 421C or 421D.

Arrangement 424 may include a memory chiplet placed in the center such that the memory chiplet in the center may communicate with the connected chiplets in all four directions. For example, memory chiplet 426 may send data to the connected compute chiplets using four sides of memory chiplet 426. Memory chiplet 428 is only connected to two compute chiplets.

Arrangement 430 is another variation of arrangement 424 with no memory chiplet in the center. For example, compute chiplet 432 is not connected to any memory chiplet. Compute chiplet 432, however, can operate together with the neighboring compute chiplets. The neighboring compute chiplets can receive data from the connected memory chiplets.

Arrangement 434 may include a logic die in the center (illustrated by a darkened box). Logic die 436 can be connected to four compute chiplets and facilitate the communications between the connected compute chiplets.

In any of the foregoing example arrangements, or other arrangements wherein a compute chiplet is coupled to multiple memory chiplets through various shoreline interfaces on the compute chiplet, data received from the multiple memory chiplets can be multiplexed at the compute chiplet. In this regard, the compute chiplet may access from each memory chiplet only a limited subset of data needed, as opposed to accessing larger data sets wherein only a portion of such larger data sets are used. Accordingly, the bandwidth of memory available to other chiplets may be increased.

The example arrangements can also be used to accommodate different phases of computation. For example, referring to arrangement 408, compute chiplet 413 at the center of the arrangement may have four shoreline interfaces, one at each edge, each of which couples to a different memory chiplet. The compute chiplet can dynamically adjust how bandwidth is allocated to each of the four memory chiplets. Similarly, the compute chiplet can dynamically adjust how data is multiplexed from the different memory chiplets. Because of this capability of dynamic configuration, the compute chiplet can be adjusted to accommodate different phases of computation. For example, an operation may include multiple phases of computation, with each phase having different requirements. Rather than using different hardware to meet the requirements of each phase, the same arrangement of compute chiplets and memory chiplets can be used and dynamically configured through the shoreline interfaces.

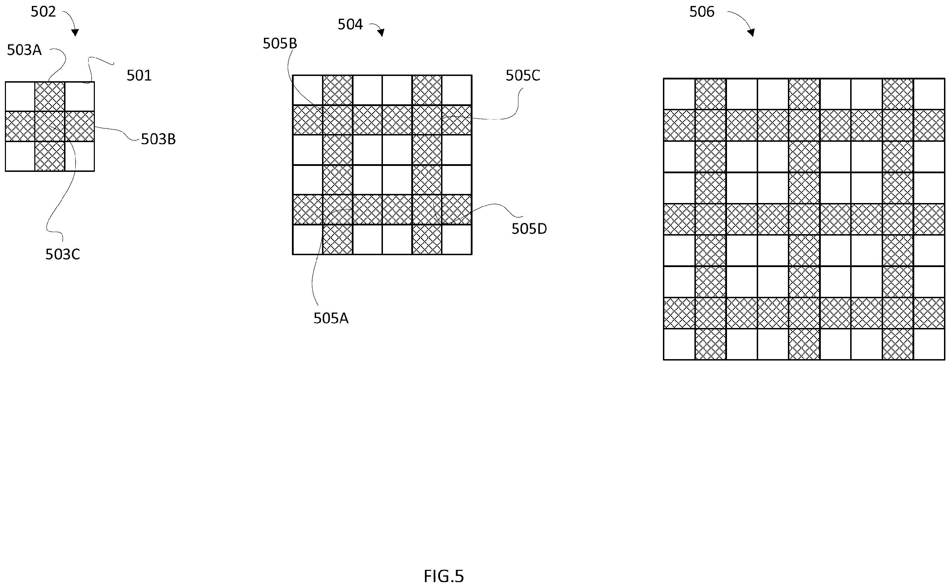

FIG. 5 illustrates an example of repeated tile configurations of memory and compute chiplets. Each of the various arrangements of chiplets described in connection with FIG. 4 can be combined to form a larger and repeated tile configuration of the chiplets. For example, arrangement 502 is equivalent to arrangement 416 depicted in FIG. 4. Arrangement 502 may include five memory chiplets (illustrated by shadowed boxes) and four compute chiplets. As described with respect to FIG. 4, memory chiplet 503C may be placed in the center and communicate with four other memory chiplets in four directions. Compute chiplet 501 may be connected to two memory chiplets 503A and 503B. Memory chiplets 503A and 503B may retrieve data from memory chiplet 503C.

Arrangement 502 may be combined with three identical arrangements 502 to form arrangement 504. Arrangement 504 may include twenty (20) memory chiplets (illustrated by shadowed boxes) and sixteen (16) compute chiplets. By connecting every memory chiplet, each compute chiplet may utilize more data. Each memory chiplet that is surrounded by other memory chiplets such as memory chiplets 505A-D may multiplex the data received from the connected chiplets. The multiplexed data may be sent to compute chiplets for processing. Arrangement 502 may be repeated and combined in a 3x3 manner to form arrangement 506. Arrangement 506 may include forty-five (45) memory chipsets (illustrated by shadowed boxes) and thirty-six (26) compute chiplets. By combining one or more arrangement 504 together, memory chiplets can multiplex an increased amount of data compared to memory chiplets in arrangement 504.

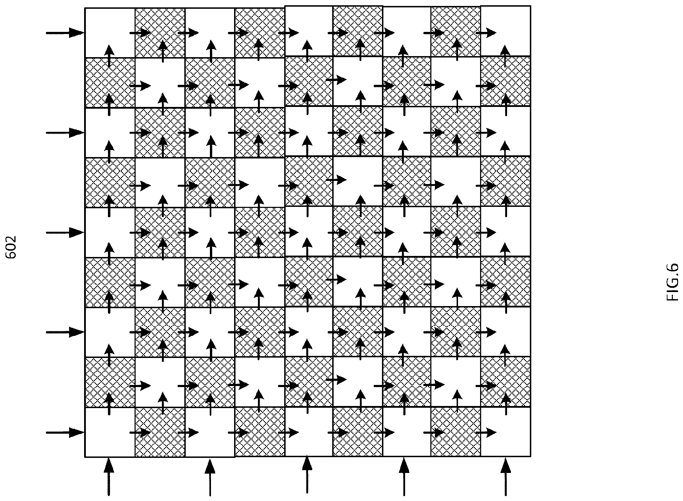

FIG. 6 illustrates an example systolic array formed from an arrangement of memory and compute chiplets having shoreline interfaces as described above. Systolic arrays may be used for specific operations to perform massively parallel integration or data sorting tasks. To enhance parallel integration or data sorting tasks, memory chiplets may be configured to connect to compute chiplets using multiple sides of the memory chiplets. For example, compute chiplets in a first column and a first row of an array may receive input data, and use the input to perform one or more operations. The compute chiplets in the first column and first row may output results from the operations to adjacent memory chiplets to an immediate right and below. Such memory chiplets, upon receiving the results of the operations, provide data to adjacent compute chiplets to an immediate right and below, such that those compute chiplets can perform further operations. Such process may continue until a final output is provided by one or more chiplets in a bottom row and/or right-most column.

Although an example systolic array is described with reference to FIG. 6, memory and compute chiplets with shoreline interfaces as described herein may be implemented in a variety of different arrangements. These arrangements can vary, for example, based on the pattern or rate at which data is transmitted from chiplet to chiplet. For instance, some chiplets may be bypassed on certain clock cycles. Other architectures are also possible, such as a sea-of-cores architecture, or architectures with different chiplets assigned for different performance modes or functions.

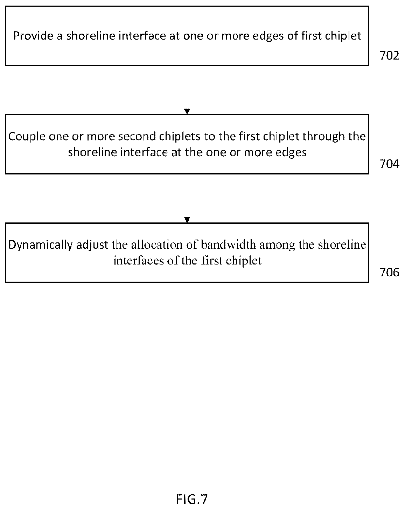

FIG. 7 is a flow diagram illustrating an example method for multi-directional sharing and multiplexing of data using HBIs. According to block 702, a first chiplet is provided with a shoreline interface at one or more edges of the first chiplet. For example, the chiplet may be provided with a first shoreline interface extending along a first edge, a second shoreline interface extending along a second edge, etc. Any arrangement of shorelines interfaces is possible, as described above in connection with Fig. 2. The chiplet may be a memory chiplet or a compute chiplet.

According to block 704, one or more second chiplets may be coupled to the first chiplet through the shoreline interfaces at the one or more edges. For example, one second chiplet can be coupled through the first shoreline interface at the first edge of the first chiplet, another second chiplet can be coupled through the second shoreline interface at the second edge of the first chiplet, etc. The one or more second chiplets may also be compute chiplets or memory chiplets. According to one example, where the first chiplet is a compute chiplet, the second chiplets may be memory chiplets. The one or more second chiplets may also include shoreline interfaces at one or more of their respective edges.

According to block 706, the allocation of bandwidth among the shoreline interfaces of the first chiplet may be dynamically adjusted. For example, data may be transmitted from the first chiplet to one of the second chiplets at a same rate or at a different rate than data transmitted to another one of the second chiplets. Similarly, data received from the second chiplets may be received at a same rate or different rates, depending on whether bandwidth is allocated evenly among the second chiplets or unevenly. In some examples, the allocation of bandwidth may be dynamically changed. For example, a density of bandwidth per millimeter may be changed with respect to the connectivity to any connected chiplets by activating more independent channels and/or pseudo-channels. The bandwidth may be changed based on, for example, performance, a type of operation to be performed, a phase of computations, etc.

The electronic circuit with high bandwidth interfaces described herein is beneficial at least in that it provides for sharing multiplexing of data based on efficient tile configurations that may maximize the use of high bandwidth and capacity memories in packages while minimizing the cost. High bandwidth can mitigate or obviate memory bandwidth bottlenecks in executing certain workloads, such as workloads for training or processing input through a machine learning model, e.g., a large language model.

In this specification, the phrase "configured to" is used in different contexts related to computer systems, hardware, or part of a computer program, engine, or module. When a system is said to be configured to perform one or more operations, this means that the system has appropriate software, firmware, and/or hardware installed on the system that, when in operation, causes the system to perform the one or more operations. When some hardware is said to be configured to perform one or more operations, this means that the hardware includes one or more circuits that, when in operation, receive input and generate output according to the input and corresponding to the one or more operations. When a computer program, engine, or module is said to be configured to perform one or more operations, this means that the computer program includes one or more program instructions, that when executed by one or more computers, causes the one or more computers to perform the one or more operations.

Although the technology herein has been described with reference to particular examples, it is to be understood that these examples are merely illustrative of the principles and applications of the present technology. It is therefore to be understood that numerous modifications may be made and that other arrangements may be devised without departing from the spirit and scope of the present technology as defined by the appended claims.

Unless otherwise stated, the foregoing alternative examples are not mutually exclusive, but may be implemented in various combinations to achieve unique advantages. As these and other variations and combinations of the features discussed above can be utilized without departing from the subject matter defined by the claims, the foregoing description should be taken by way of illustration rather than by way of limitation of the subject matter defined by the claims. In addition, the provision of the examples described herein, as well as clauses phrased as "such as," "including" and the like, should not be interpreted as limiting the subject matter of the claims to the specific examples; rather, the examples are intended to illustrate only one of many possible implementations. Further, the same reference numbers in different drawings can identify the same or similar elements.

## Claims

1. An electronic circuit, comprising:
a first chiplet having a first surface and a plurality of edges at a perimeter of the first surface, and at least one shoreline interface at one or more of the plurality of edges, the at least one shoreline interface extending along a length of the first chiplet; and
at least one second chiplet having a second surface and a plurality of edges at a perimeter of the second surface, and at least one die-to-die interface being located at one of the plurality of edges;
wherein the at least one shoreline interface is adapted to couple to the at least one die-to-die interface; and
wherein at least one of the first or second chiplet is a high bandwidth memory chiplet and at least one of the first or second chiplet is a compute chiplet.

2. The electronic circuit of claim 1, wherein the shoreline interface comprises multiple channels.

3. The electronic circuit of claim 2, further comprising a third chiplet having an interface coupled to a second shoreline interface of the first chiplet.

4. The electronic circuit of claim 3, wherein the first chiplet is configured to communicate with the second chiplet and the third chiplet at equal bandwidth.

5. The electronic circuit of claim 3, wherein the first chiplet is configured to communicate with the second chiplet and the third chiplet at uneven bandwidths; and wherein optionally the first chiplet is configured to dynamically change relative bandwidth for a communication with the second chiplet as compared to a communication with the third chiplet.

6. The electronic circuit of claim 6, wherein the first chiplet comprises a multicast module configured to dynamically allocate bandwidth among the shoreline interface and the second shoreline interface based on a performance rate.

7. The electronic circuit of one of claims 3 to 6, wherein the first chiplet is configured to multiplex data received from the second chiplet and the third chiplet.

8. The electronic circuit of one of claims 2 to 7, wherein the multiple channels of the shoreline interface are configured to be activated or deactivated.

9. The electronic circuit of one of claims 3 to 8, further comprising a fourth chiplet,
wherein the first, second, third, and fourth chiplets are configured to be arranged in a tile shape such that each chiplet couples to at least two other chiplets; and
optionally the first, second, third, and fourth chiplets are configured to form a systolic array.

10. The electronic circuit of one of claims 1 to 9, wherein the shoreline interface is configured to extend along an entire length of the first chiplet; or
wherein the shoreline interface is configured to extend along less than an entire length of the first chiplet.

11. A high bandwidth memory (HBM) chiplet, comprising:
a first surface;
a plurality of edges at a perimeter of the first surface; and
at least one shoreline interface at one or more of the plurality of edges, the at least one shoreline interface extending along a length of the HBM chiplet;
wherein the at least one shoreline interface is adapted to couple to a die-to-die interface located at one of a plurality of edges of a first connected chiplet.

12. The HBM chiplet of claim 11, wherein the shoreline interface comprises multiple channels.

13. The HBM chiplet of claim 12, further comprising a second shoreline interface adapted to be coupled to an interface of a second connected chiplet; and
wherein optionally the HBM chiplet is configured to communicate with the first connected chiplet and the second connected chiplet either at equal bandwidth or at uneven bandwith.

14. The HBM chiplet of claim 13, wherein, if the HBM chiplet is configured to communicate with the first connected chiplet and the second connected chiplet at uneven bandwith, the HBM chiplet is further configured to dynamically change relative bandwidth for a communication with the first connected chiplet as compared to a communication with the second connected chiplet.

15. A compute chiplet, comprising:
a first surface;
a plurality of edges at a perimeter of the first surface; and
at least one die-to-die interface being located at one of the plurality of edges;
wherein the at least one die-to-die interface is adapted to be coupled to at least one shoreline interface of a first connected chiplet, the first connected chiplet comprising at least one shoreline interface extending along a length of the first connected chiplet.
